# EUROPÄISCHE PATENTSCHRIFT

(11) **EP 0 790 679 B1**
(45) Veröffentlichungstag und Bekanntmachung des Hinweises auf die Patenterteilung: **05.09.2001**
(21) Anmeldenummer: 97400348.5
(22) Anmeldetag: 17.02.1997
(51) Int. Cl.: H01S 5/02, G02B 6/43, G02F 1/313, G02F 1/015, H01L 27/15

(54) **Monolithisch integriertes optisches Halbleiterbauelement und Herstellungsverfahren**
Monolithically integrated optical semiconductor assembly and method for making the same
Dispositif optique à semi-conducteur intégré monolithiquement et méthode de fabrication

(30) Priorität: 16.02.1996 DE 19605794
(43) Veröffentlichungstag der Anmeldung: 20.08.1997
(73) Patentinhaber: ALCATEL, 75008 Paris (FR)
(72) Erfinder: Laube, Gert, Dr., 70439 Stuttgart (DE); Schilling, Michael, 70499 Stuttgart (DE); Wünstel, Klaus, Dr., 70701 Schwieberdingen (DE); Idler, Wilfried, 71706 Markgröningen (DE); Daub, Karin, 71739 Oberriexingen (DE); Lach, Eugen, Dr., 71672 Marbach (DE)
(74) Vertreter: Schätzle, Albin, Dipl.-Phys.

(56) Entgegenhaltungen:
- EP-A- 0 558 089
- EP-A- 0 612 129
- EP-A- 0 662 628
- EP-A- 0 692 853
- ZUCKER J E: "Strained quantum wells for polarization-independent electrooptic waveguide switches" JOURNAL OF LIGHTWAVE TECHNOLOGY, Bd. 10, Nr. 12, 1.Dezember 1992, Seiten 1926-1930, XP000367894
- IDO T ET AL: "High-speed MQW electroabsorption optical modulators integrated with low-loss waveguides" IEEE PHOTONICS TECHNOLOGY LETTERS, Bd. 7, Nr. 2, 1.Februar 1995, Seiten 170-172, XP000488090

## Beschreibung

Die Erfindung betrifft ein integriertes optoelektronisches Halbleiterbauelement gemäß dem Oberbegriff des Patentanspruchs 1 sowie ein Verfahren zur Herstellung eines solchen Halbleiterbauelementes.

Eine Ausführung eines solchen Bauelementes ist bekannt aus der Veröffentlichung der Europäischen Patentanmeldung EP 616 243. Es ist dort ein optischer Raumschalter beschrieben, der optische Wellenleiter mit aktiven, d.h. gesteuert lichtverstärkenden oder lichtabsorbierenden Wellenleiterbereichen und passiven, d.h. Licht unverstärkt weiterleitenden Wellenleiterbereichen enthält. Die optischen Wellenleiter enthalten ein Halbleiterschichtpaket, dessen Halbleiterschichten in den aktiven Wellenleiterbereichen eine andere Schichtdicke aufweisen als in den passiven Wellenleiterbereichen. Es ist auch ein Verfahren angegeben, mit dem die aktiven und passiven Wellenleiterbereiche in einem einzigen Beschichtungsprozeß aufgebracht werden können. Dieses Verfahren nutzt aus, daß in mit einer dielektrischen Schicht abgedeckten Bereichen eines Substrates kein Halbleitermaterial aufwächst und daß die Wachstumsgeschwindigkeit zwischen mit einer dielektrischen Schicht maskierten Bereichen erhöht ist, abhängig von der Größe der benachbarten maskierten Fläche.

Der beschriebene optische Raumschalter weist jedoch den Nachteil auf, daß er polarisationsabhängig arbeitet, d.h. daß Lichtsignale mit unterschiedlicher Polarisationsrichtung in den aktiven Wellenleiterbereichen unterschiedlich stark verstärkt oder absorbiert werden.

Des weiteren ist aus einem Artikel von M. Schilling et al, "Wavelength converter based on integrated all-active three-port Mach-Zehnder interferometer", El. Lett Vol. 30 No. 25, 1994, ein Wellenlängenkonverter mit durchgehend aktiven Wellenleitern bekannt. Auch dieses Halbleiterbauelement arbeitet polarisationsabhängig und benötigt für die verschiedenen aktiven Wellenleiterbereich eine aufwendige Ansteuerung bei hohem Strombedarf.

In einem Artikel von M. Aoki et al, "New Photonic Device Integration by Selective-Area MOVPE and Its Application to Optical Modulator/Laser Integration", IEEE Microw. and Opt. Tech. Let. Vol. 7, No. 3, 1994 ist das in der Patentanmeldung EP 616243 verwendete Verfahren, das unter der Bezeichnung Selective Area Growth (SAG) bekannt ist, am Beispiel eines monolithisch integrierten Halbleiterbauelement mit einem Laser und einem Modulator ausführlich beschrieben. Als Halbleiterschichtpaket werden sogenannte Multiple-Quantum-Well-Schichten verwendet, das sind Halbleiterschichten mit abwechselnd einer kleinen und einer großen Bandabstandsenergie. Unter Bandabstandsenergie wird die Energiedifferenz zwischen Valenz- und Leitungsband des Halbleiters verstanden. Das Verfahren wird in dem Artikel für die monolithische Integration einer Reihe weiterer Bauelemente, insbesondere für photonisch integrierte Schaltungen empfohlen. Die nach diesem Verfahren hergestellten Bauelemente haben jedoch ebenfalls den Nachteil, daß sie polarisationsabhängig arbeiten.

Ferner wird in einem Artikel von G. Coudenys et al, "Novel Growth Techniques for the Fabrication of Photonic Integrated Circuits", Mat. Res. Symp. Proc. Vol. 240, 1992, S. 15-26 als Nachteil des Selective Area Growth Verfahrens genannt, daß sich in seitlich mit einer dielektrischen Schicht maskierten Bereichen die Materialzusammensetzung des aufwachsenden Halbleitermaterials und damit dessen Gitterkonstante ändert.

In einem Artikel von M. Joma et al, "Polarization Insensitive Semiconductor Laser Amplifiers with Tensile Strained InGaAsP/InGaAsP Multiple Quantum Well Structure", Appl. Phys. Lett. Vol. 62(2), S. 121-122, 1993, ist ein optischer Verstärker mit aktiven, zugverspannten Multiple Quantum Well-Schichten beschrieben, der polarisationsunabhängig arbeitet. Dieses Bauelement enthält jedoch keine passiven Wellenleiterbereiche und ist nach einem Verfahren hergestellt, daß die Integration mit passiven Wellenleiterbereichen nicht ermöglicht.

Aus EP 0 692 853 A1 ist ein integriertes opotisches Halbleiterbauelement mit einem auf einem kristallinen Substrat angeordneten aktiven Wellenleiterbereich und einem passiven, d.h. Licht unverstärkt weiterleitenden Bereich bekannt. Es weist einem Wellenleiter auf, der ein Halbleiterschichtpaket mit Multi-Quantum-Well-Struktur (MQW) enthält, wobei die Halbleiterschichten im aktiven Bereich eine größere Schichtdicke besitzen als im passiven Bereich. Die Halbleiterschichten mit der kleineren Bandabstandsenergie sind um 0,6% zugverspannt und weisen daher eine kleinere Gitterkonstante auf als das Substrat.

Aufgabe der Erfindung ist es daher, ein integriertes optoelektronisches Halbleiterbauelement zu finden, daß Lichtsignale mit beliebiger Polarisationsrichtung in gleicher Weise verarbeiten kann. Desweiteren ist es Aufgabe der Erfindung, ein Verfahren anzugeben, nach dem ein solches integriertes optoelektronisches Halbleiterbauelement hergestellt werden kann.

Die Aufgabe wird hinsichtlich des Bauelementes durch die Merkmale des Patentanspruchs 1, hinsichtlich des Verfahrens durch die Merkmale des Patentanspruchs 5 gelöst. Vorteilhafte Ausgestaltungen sind den abhängigen Patentansprüchen zu entnehmen.

Anhand der Figuren 1 bis 4 sollen nachfolgend zwei Ausführungsformen eines erfindungsgemäßen Bauelementes und des erfindungsgemäßen Herstellungsverfahrens beschrieben werden.

Es zeigen:
- Figur 1: eine schematische räumliche Ansicht eines ersten Ausführungsbeispiels,
- Figur 2: einen Schnitt senkrecht zum Substrat durch das Wellenleiterschichtpaket entlang der Schnittlinie II-II,
- Figur 3: einen Schnitt entlang des optischen Wellenleiters im Übergangsbereich zwischen einem aktiven und einem passiven Wellenleiterbereich entlang der Schnittlinie III-III,
- Figur 4: eine schematische Aufsicht auf ein zweites Ausführungsbeispiel.

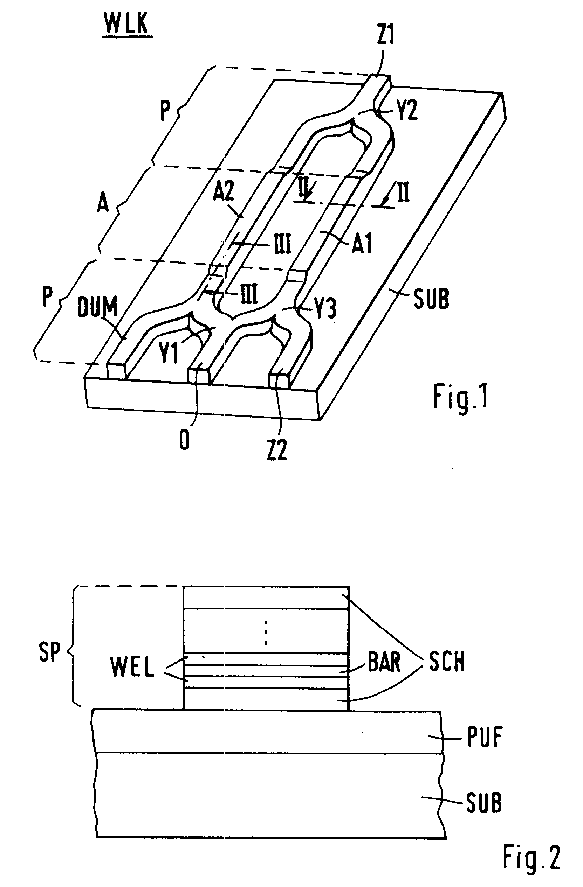

In Figur 1 ist ein erstes Ausführungsbeispiel eines erfindungsgemäßen integrierten optoelektronischen Halbleiterbauelementes dargestellt, ein sogenannter 3-port Mach-Zehnder Interferometer Wellenlängenkonverter WLK. Er besteht aus einem Substrat SUB, dem ein optischer Wellenleiter aufliegt. Der Wellenleiter hat aktive Wellenleiterbereiche A, in denen in Abhängigkeit eines injizierten Stromes hindurchtretendes Licht verstärkt werden kann, und passive Wellenleiterbereiche P, in denen eintretendes Licht unverstärkt weitergeleitet wird. Zwei aktive Wellenleiterbereiche A1 und A2 sind über zwei passive Y-förmige Verzweigungen Y1 und Y2 optisch parallelgeschaltet, so daß diese aktiven Wellenleiterbereiche A1, A2 einen gemeinsamen Zugang Z1 und einen gemeinsamen Ausgang 0 haben. Der eine aktive Wellenleiterbereich A1 besitzt über eine dritte Y-förmige Verzweigung Y3 einen zweiten Zugang Z2. Aus Symmetriegründen kann auch der zweite aktive Bereich A2 einen weiteren Zugang DUM haben, der allerdings nicht benutzt wird. In den gemeinsamen Zugang Z1 eintretendes Licht einer Wellenlänge λ₁ kann durch ein in den zweiten Zugang Z2 eintretendes Lichtsignal mit einer Wellenlänge λ₂ moduliert werden, wobei eine Sättigung der Verstärkung in dem aktiven Bereich A1 ausgenutzt wird.

Der optische Wellenleiter besteht aus einem zusammenhängenden, durchgehenden Halbleiterschichtpaket SP, das in einem einzigen Beschichtungsprozeß aufgebracht ist. In Figur 2 ist der Aufbau des Halbleiterschichtpaketes SP im Schnitt schematisch dargestellt. Es enthält abwechselnd Halbleiterschichten mit kleiner Bandabstandsenergie WELL und Halbleiterschichten mit großer Bandabstandsenergie BAR.

Ein solcher Aufbau wird als Multiple-Quantum-Well-Struktur bezeichnet. Mit Bandabstandsenergie einer Halbleiterschicht ist die Energiedifferenz zwischen Valenz- und Leitungsband des Halbleiters, aus dem die Schicht besteht, bezeichnet. Die oberste und unterste Halbleiterschicht ist eine Wellenleiterschicht SCH. Zwischen dem Substrat SUB und dem Halbleiterschichtpaket SP kann sich noch eine Pufferschicht PUF befinden. Die Anzahl der Halbleiterschichten mit der großen und der kleinen Bandabstandsenergie beträgt je zwischen 1 und 30, vorzugsweise 5.

Nicht gezeigt sind in Figur 1 und Figur 2 eine oder mehrere Deckschichten und eine Metallkontaktschicht, die über dem Halbleiterschichtpaket SP aufgebracht sind.

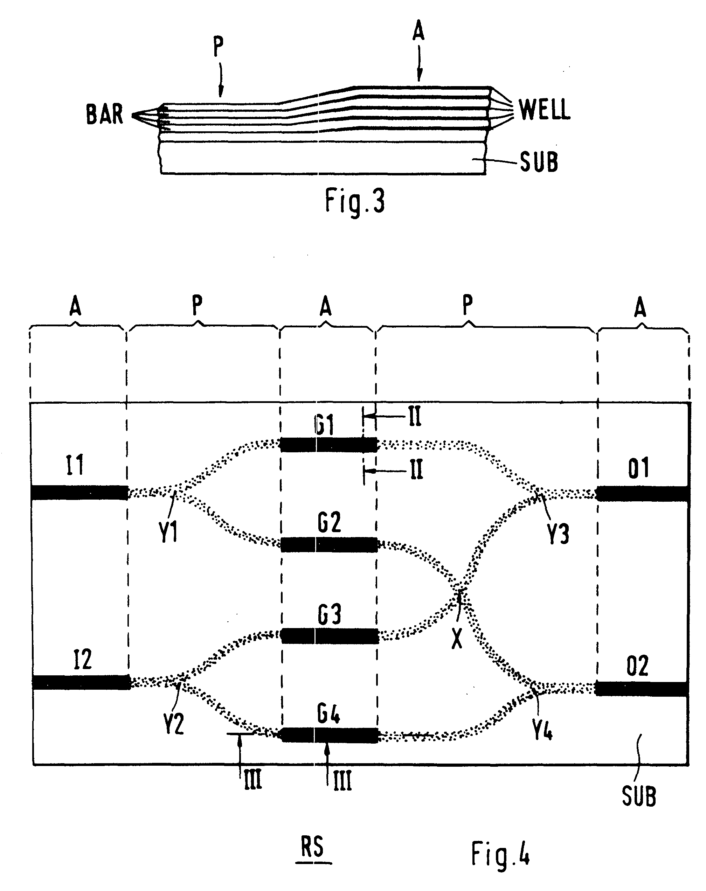

In den aktiven Wellenleiterbereichen A sind die Halbleiterschichten WELL und BAR dicker als in den passiven Wellenleiterbereichen P. Dies ist in Figur 3 dargestellt, die einen Schnitt längs eines Wellenleiters im Übergangsbereich zwischen aktivem und passivem Wellenleiterbereich zeigt. Erst durch diesen Schichtdickenunterschied ist es möglich, die verschiedenen Bereiche des optischen Wellenleiters bei einer bestimmten Lichtwellenlänge als aktive, d.h. gesteuert lichtverstärkende oder -absorbierende und als passive, d. h. Licht unverstärkt weiterleitende Wellenleiterbereiche zu betreiben. Durchgehende, zusammenhängende Halbleiterschichten, die in aktiven Wellenleiterbereichen eine größere Schichtdicke haben als in passiven, lassen sich nach einem als Selective Area Growth (SAG) bekannten Verfahren herstellen, indem der Wellenleiter in den aktiven Bereichen zwischen mit einer dielektrischen Schicht abgedeckte Bereiche der Substratoberfläche angeordnet wird.

In diesem ersten Ausführungsbeispiel bestehen Substrat SUB und Pufferschicht PUF aus n-dotierten InP, die Halbleiterschichten mit der hohen Bandabstandsenergie BAR und die Wellenleiterschichten SCH aus undotiertem InGaAsP und die Halbleiterschichten mit der kleinen Bandabstandsenergie WELL aus undotiertem InGaAs oder InGaAsP. Für die in Figur 1 nicht gezeigten Deckschichten wird p-dotiertes InP verwendet. Die genannten Dotierungen können auch vom jeweils umgekehrten Ladungsträgertyp sein. Auch können die Wellenleiterschichten SCH schwach dotiert sein. Für die Wellenleiterschichten SCH und die Halbleiterschichten BAR und WELL bieten sich auch andere ternäre oder quaternäre Verbindungen wie InAIAs oder InGaAIAs an. Allgemein lassen sich neben verschiedenen Halbleitern vom III/V-Verbindungstyp auch Halbleiter vom II/VI-oder IV/IV-Verbindungstyp einsetzen.

Während die Zusammensetzung der Halbleiterschichten mit der hohen Bandabstandsenergie BAR so gewählt ist, daß die Gitterkonstante dieser Schichten in den passiven Wellenleiterbereichen P an die des Substrates SUB angepaßt ist, ist bei den Halbleiterschichten mit der kleinen Bandabstandsenergie WELL die Zusammensetzung so, daß sie eine kleinere Gitterkonstante haben als das Substrat (SUB).

Dadurch stehen diese Schichten unter biaxialer Zugspannung, was eine Änderung der Energiebandstruktur bewirkt. Es läßt sich so erreichen, daß bei einer geeigneten Zugverspannung der Halbleiterschichten in den aktiven Wellenleiterbereichen in Substratebene polarisiertes Licht eines bestimmten Wellenlängenbereiches im gleichen Maße verstärkt oder absorbiert wird wie senkrecht zur Substratebene polarisiertes Licht. Die Arbeitsweise des Halbleiterbauelementes ist dann unabhängig von der Polarisationsrichtung eines Lichtsignals. Polarisationsunabhängigkeit wird bei dem vorliegenden Aufbau bei einer Zugverspannung von etwa 0,3 % erreicht, d.h. die Gitterkonstante der Halbleiterschichten mit der kleinen Bandabstandsenergie WELL ist um 0,3 % kleiner als die des Substrates SUB. Dazu wird der Gehalt an Gallium in den Halbleiterschichten mit der kleinen Bandabstandsenergie WELL gegenüber der Zusammensetzung unverspannter Halbleiterschichten erhöht. Der übliche Toleranzbereich für die Materialzusammensetzung einer unverspannten Halbleiterschicht ist dabei so, daß sich deren Gitterkonstante nicht mehr als ± 0,02 % von der Gitterkonstanten des Substrates unterscheidet.

Ganz besonders kommt es für die Polarisationsunabhängigkeit auf die Verspannung in den Halbleiterschichten mit der kleinen Bandabstandsenergie WELL in den aktiven Wellenleiterbereichen A an. Es ist demnach wichtig, daß die beschriebene Zugverspannung von 0,3 % in den aktiven Wellenleiterbereichen A herrscht. Nun werden bei der Herstellung des Halbleiterbauelementes die aktiven Wellenleiterbereiche A zwischen mit einer dielektrischen Schicht abgedeckte Bereiche der Substratoberfläche angeordnet. Durch den Einfluß dieser seitlichen Maskierung ist die Materialzusammensetzung und damit auch die Gitterkonstante der Halbleiterschichten BAR und WELL in den aktiven Wellenleiterbereichen A gegenüber der Materialzusammensetzung in den passiven Wellenleiterbereichen P verändert. Dieser Effekt muß kompensiert werden, um gezielt die gewünschte Zugverspannung in den aktiven Wellenleiterbereichen A zu erhalten.

In der Herstellung des Halbleiterbauelementes kann allerdings nur die Gitterkonstante in den passiven Wellenleiterbereichen P kontrolliert eingestellt werden, da nur diese einer direkten Messung z.B. mittels Röntgendiffraktometrie zugänglich ist. An den aktiven Wellenleiterbereichen A kann keine direkte Bestimmung der Gitterkonstante vorgenommen werden, da diese Strukturen nur einige bis einige zehn Mikrometer breit sind. Aus diesem Grund muß in den passiven Wellenleiterbereichen P eine anhand von Berechnungen oder experimentellen Daten bestimmte Gitterkonstante eingestellt werden, um in den aktiven Wellenleiterbereichen A die gewünschte Zugverspannung zu erzielen.

In den passiven Wellenleiterbereichen P entsteht demnach durch die Kompensation des genannten Effektes eine andere Verspannung der Halbleiterschichten als in den aktiven Wellenleiterbereichen A. Der Einfluß von Verspannungen auf die Lichtwellenleitung ist in den passiven Wellenleiterbereichen P jedoch gering und spielt daher für die Polarisationsunabhängigkeit des Bauelementes nur eine untergeordnete Rolle. Im vorliegenden Fall ist der Gehalt an Indium in den aktiven Wellenleiterbereichen A erhöht, so daß die Gitterkonstante der aufgewachsenen Halbleiterschichten größer ist als in den passiven Wellenleiterbereichen P. Dies führt zu einer Druckverspannung in den aktiven Wellenleiterbereichen A, die durch zusätzliche Erhöhung des Galliumgehaltes in den Halbleiterschichten mit der kleinen Bandabstandsenergie WELL ausgeglichen werden muß.

Der Wellenlängenkonverter arbeitet bei einer Zugverspannung von 0,3 % in den aktiven A und 0,6 % in den passiven P Wellenleiterbereichen bei einer Lichtwellenlänge von etwa 1550 nm polarisationsunabhängig. Dabei beträgt die Dicke d der Halbleiterschichten mit der kleinen Bandabstandsenergie WELL in den aktiven Wellenleiterbereichen A etwa d_{A} = 11nm und in den passiven Bereichen P etwa d_{P} = 7nm. Durch den Dickenunterschied liegt die Wellenlänge, bei der Licht im passiven Bereich P verstärkt absorbiert wird bei 1430 nm, und damit deutlich getrennt von der Arbeitswellenlänge um 1550 nm der aktiven Wellenleiterbereiche A. Dadurch müssen die passiven Wellenleiterbereiche P nicht durch Injizieren eines Pumpstromes aktiv betrieben werden.

Die erfindungsgemäße Möglichkeit, bei einer vorgegebenen Geometrie des optischen Wellenleiters Polarisationsunabhängigkeit zu erreichen besteht darin, in die Halbleiterschichten mit der großen Bandabstandsenergie BAR durch eine größere Gitterkonstante in den aktiven Wellenleiterbereichen A eine zusätzliche Druckspannung einzuführen. Damit steht neben der Zugspannung in den Halbleiterschichten mit der kleinen Bandabstandsenergie WELL die Druckspannung in den Halbleiterschichten mit der großen Bandabstandsenergie BAR als Freiheitsgrad für die Herstellung eines Halbleiterbauelementes zur Verfügung.

Figur 4 zeigt ein zweites Ausführungsbeispiel eines erfindungsgemäßen integrierten optoelektronischen Halbleiterbauelementes, einen optischen 2 x 2 Raumschalter RS. In der Abbildung ist schematisch der optische Wellenleiter dargestellt, der aus aktiven Wellenleiterbereichen A und passiven Wellenleiterbereichen P besteht. Der optische Raumschalter RS hat die gleiche, in Figur 2 gezeigte Schichtenfolge wie der Wellenlängenkonverter WLK im ersten Ausführungsbeispiel.

Bei dem optischen Raumschalter RS werden zwei aktive Wellenleiterbereiche I1 und I2 als optische Verstärker betrieben und bilden zwei Eingangsverstärker. Über je eine passive Y-förmige Verzweigung Y1, Y2 sind die aktiven Wellenleiterbereiche I1, I2 mit je zwei weiteren aktiven Wellenleiterbereichen G1 bis G4 verbunden, die als optische Schalter betrieben werden und je nach elektrischer Ansteuerung einfallendes Licht absorbieren oder verstärken. Über zwei weitere passive Y-förmige Verzweigungen sind die vier optischen Schalter G1 bis G4 mit zwei weiteren, als Ausgangsverstärker arbeitenden, aktiven Wellenleiterbereichen 01 und 02 verbunden, und zwar so, daß von jedem Eingangsverstärker I1, I2 eine Wellenleiterverbindung zu jedem Ausgangsverstärker 01, 02 besteht. Dabei tritt eine Kreuzung X zweier Wellenleiterzweige auf. Diese ist so gestaltet, daß Licht aus einem Wellenleiterzweig nicht in den kreuzenden Wellenleiterzweig gelangen kann.

Wie auch im ersten Ausführungsbeispiel weist die Schichtdicke der Halbleiterschichten den in Figur 3 gezeigten Verlauf auf, so daß die Halbleiterschichten in den aktiven Bereichen A eine größere Schichtdicke haben als in den passiven Bereichen P. Substrat SUB und Pufferschicht PUF sind aus InP, die Halbleiterschichten mit der hohen Bandabstandsenergie BAR aus InGaAsP mit in den passiven Wellenleiterbereichen P an das Substrat SUB angepaßter Gitterkonstante. Die Halbleiterschichten mit der kleinen Bandabstandsenergie WELL sind aus InGaAs oder InGaAsP mit gegenüber Gitter-angepaßten Halbleiterschichten erhöhtem Galliumgehalt und dadurch kleinerer Gitterkonstante.

Das Verfahren, nach dem die Halbleiterbauelemente WLK, RS der beiden Ausführungsbeispiele hergestellt sind, hat im wesentlichen die folgenden Schritte:

In einem ersten Schritt wird auf ein Substrat SUB aus InP als Maske eine dielektrische Schicht z.B. aus SiO₂ aufgebracht. Diese ist so strukturiert, daß schmale Streifen, die den späteren optischen Wellenleiter definieren, frei bleiben. In aktiven Wellenleiterbereichen A ist der schmale Streifen von großflächig maskierten Bereichen seitlich begrenzt. In passiven Wellenleiterbereichen P fehlt eine seitliche Begrenzung durch die Maske oder es besteht eine nur schmale seitliche Maskierung.

In einem zweiten Schritt wird in einem einzigen Beschichtungsprozeß ohne zwischengeschaltete Maskierungs- und Ätzschritte das Halbleiterschichtpaket SP aufgebracht. Der Beschichtungsprozeß enthält eine Reihe von Epitaxieschritten, bei denen nacheinander die einzelnen Halbleiterschichten durch Abscheidung von Halbleitermaterial aus der Gasphase aufgebracht werden. Zur Abscheidung wird das Metal-Organic Vapor-Phase Epitaxie (MOVPE) Verfahren verwendet. In den einzelnen Epitaxieschritten werden nacheinander zunächst eine Pufferschicht PUF aus InP, eine Wellenleiterschicht SCH aus InGaAsP, dann abwechselnd je eine Halbleiterschicht WELL aus InGaAs oder InGaAsP mit kleiner Bandabstandsenergie und eine Halbleiterschicht BAR aus InGaAsP mit großer Bandabstandsenergie und abschließend eine zweite Wellenleiterschicht SCH aus InGaAsP aufgebracht. Die Zusammensetzung der Bestandteile in der Gasphase wird dabei jeweils so eingestellt, daß die Wellenleiterschichten SCH und die Halbleiterschichten mit der großen Bandabstandsenergie BAR mit einer in den passiven Wellenleiterbereichen P an die Gitterkonstante des Substrates SUB angepaßten Gitterkonstante und die Halbleiterschichten mit der kleinen Bandabstandsenergie WELL mit einer in den aktiven Wellenleiterbereichen A um etwa 0,3 % kleineren Gitterkonstante aufwachsen.

In den passiven Wellenleiterbereichen P oder bei auf einem unmaskierten Probesubstrat aufgewachsenen Halbleiterschichten ist die Gitterkonstante der Halbleiterschichten mit der kleinen Bandabstandsenergie WELL bei richtiger Einstellung in den Ausführungsbeispielen um etwa 0,6 % kleiner als die des Substrates SUB: Dies kann z. B. mittels Röntgendiffraktometrie nachgemessen werden. Im allgemeinen Fall muß einer in aktiven Wellenleiterbereichen A gewünschten Gitterkonstante ein Korrekturwert addiert werden. Dieser Korrekturwert ist anhand von Simulationsberechnungen oder experimentellen Daten, z. B. aus Fluoreszenzlichtmessungen oder Messungen der Polarisationsabhängigkeit fertiger Halbleiterbauelemente, zu bestimmen. Die Materialzusammensetzung der Bestandteile in der Gasphase ist dann so zu wählen, daß die Halbleiterschichten mit der kleinen Bandabstandsenergie WELL in den passiven Wellenleiterbereichen P mit dieser korrigierten Gitterkonstanten aufwachsen.

In einem dritten Schritt wird die dielektrische Schicht wieder entfernt und im Falle, daß eine seitliche Begrenzung durch die Maske in den passiven Wellenleiterbereichen P fehlte, wird der optische Wellenleiter in diesen Bereichen durch Ätzen aus dem Wellenleiterschichtpaket SP gebildet. Anschließend werden eine oder mehrere Deckschichten z.B. aus InP sowie eine Metallkontaktschicht aufgebracht.

## Patentansprüche

1. Integriertes optoelektronisches Halbleiterbauelement mit auf einem kristallinen Substrat (SUB) angeordneten aktiven (A) und passiven (P) optischen Wellenleiterbereichen, die in Lichtausbreitungsrichtung langgestreckte, schmale Teile eines durchgehenden, zusammenhängenden Halbleiterschichtpaketes (SP) enthalten, dieses Halbleiterschichtpaket eine Mehrzahl von Halbleiterschichten mit abwechselnd einer kleinen (WELL) und einer großen (BAR) Bandabstandsenergie hat und die Halbleiterschichten in den aktiven Wellenleiterbereichen (A) eine größere Schichtdicke besitzen als in den passiven Wellenleiterbereichen (P), wobei die Halbleiterschichten mit der kleinen Bandabstandsenergie (WELL) zugverspannt sind,
**dadurch gekennzeichnet,**daß
die Halbleiterschichten mit der kleinen Bandabstandsenergie (WELL) derart biaxial zugverspannt sind, daß in den aktiven Wellenleiterbereichen in Substratebene polarisiertes Licht eines bestimmten Wellenlängenbereichs im gleichen Maße verstärkt oder absorbiert wird, wie senkrecht zur Substratebene polarisiertes Licht, und daß die Halbleiterschichten mit der großen Bandabstandsenergie (BAR) in den aktiven Bereichen (A) eine größere Gitterkonstante aufweisen als das Substrat (SUB).

2. Halbleiterbauelement gemäß Anspruch 1, **dadurch gekennzeichnet**, daß die Halbleiterschichten mit der kleinen Bandabstandsenergie (WELL) in den passiven Bereichen (P) eine kleinere Gitterkonstante aufweisen als in den aktiven Bereichen (A).

3. Halbleiterbauelement gemäß Anspruch 1 oder 2, **dadurch gekennzeichnet**, daß die Halbleiterschichten mit der großen Bandabstandsenergie (BAR) in den passiven Bereichen (P) dieselbe Gitterkonstante aufweisen wie das Substrat (SUB).

4. Halbleiterbauelement nach einem der Ansprüche 1 bis 3, **dadurch gekennzeichnet**, daß zwei aktive Wellenleiterbereiche (A1, A2) über passive Y-förmige Verzweigungen (Y1, Y2) optisch parallelgeschaltet sind und einen gemeinsamen lichtleitenden Zugang (Z1) haben und der eine aktive Wellenleiterbereich (A1) über eine weitere passive Y-förmige Verzweigung (Y3) einen zweiten lichtleitenden Zugang (Z2) hat.

5. Verfahren zur Herstellung eines integrierten optoelektronischen Halbleiterbauelementes mit auf einem Substrat (SUB) angeordneten aktiven (A) und passiven (P) optischen Wellenleiterbereichen, die jeweils eine Mehrzahl von Halbleiterschichten (SP) enthalten, bei dem die aktiven Wellenleiterbereiche zwischen mit einer dielektrischen Schicht abgedeckten Bereichen der Substratoberfläche angeordnet werden und die aktiven und passiven Wellenleiterbereiche in einem einzigen Beschichtungsprozeß durch Abscheidung von Halbleitermaterial aus der Gasphase aufgebracht werden,
**dadurch gekennzeichnet**, daß
die Zusammensetzung der Bestandteile in der Gasphase so eingestellt wird, daß die Halbleiterschichten mit der kleinen Bandabstandsenergie (WELL) derart biaxial zugverspannt sind, daß in den aktiven Wellenleiterbereichen in Substratebene polarisiertes Licht eines bestimmten Wellenlängenbereichs im gleichen Maße verstärkt oder absorbiert wird, wie senkrecht zur Substratebene polarisiertes Licht, und daß die Halbleiterschichten mit der großen Bandabstandsenergie (BAR) in den aktiven Bereichen (A) eine größere Gitterkonstante aufweisen als das Substrat (SUB).

6. Verfahren nach Anspruch 5, **dadurch gekennzeichnet**, daß das Substrat aus InP und die Halbleiterschichten aus InGaAsP oder InGaAs bestehen und in der Gasphase der Anteil Ga-haltiger Bestandteile erhöht wird, gegenüber der Zusammensetzung der Bestandteile in der Gasphase, bei der die Halbleiterschichten mit einer an das Substrat (SUB) angepaßten Gitterkonstante aufwachsen.

## Claims

1. Integrated optoelectronic semiconductor component with active (A) and passive (P) optical waveguide regions arranged on a crystalline substrate (SUB) that contain narrow parts of a continuous coherent semiconductor layer structure (SP) longitudinally extending in the light propagation direction, the said semiconductor layer structure having a plurality of semiconductor layers with alternating small band gap energy (WELL) and large band gap energy (BAR) and the said semiconductor layers having a larger layer thickness in the active waveguide regions (A) than in the passive waveguide regions (P), the semiconductor layers with the small band gap energy (WELL) being subjected to tensile strain,
**characterised in that** the semiconductor layers with the small band gap energy (WELL) are biaxially tensile strained in such a way that in the active waveguide regions light of a specific wavelength range that is polarised in the plane of the substrate is amplified or absorbed to the same extent as light polarised perpendicular to the plane of the substrate, and that the semiconductor layers with the large band gap energy (BAR) have a larger lattice constant in the active regions (A) than the substrate (SUB).

2. Semiconductor component according to claim 1,
**characterised in that** the semiconductor layers with the small band gap energy (WELL) in the passive regions (P) have a smaller lattice constant than in the active regions (A) .

3. Semiconductor component according to claim 1 or 2,
**characterised in that** the semiconductor layers with the large band gap energy (BAR) have the same lattice constant in the passive regions (P) as the substrate (SUB).

4. Semiconductor component according to one of claims 1 to 3, **characterised in that** two active waveguide regions (A1, A2) are optically connected in parallel via passive Y-shaped branches (Y1, Y2) and have a common light-conducting input (Z1), and one active waveguide region (A1) has a second light-conducting input (Z2) through a further passive Y-shaped branch (Y3).

5. Process for the manufacture of an integrated optoelectronic semiconductor component with active (A) and passive (P) optical waveguide regions arranged on a substrate (SUB) that in each case contain a plurality of semiconductor layers (SP), in which the active waveguide regions are arranged between regions of the substrate surface covered with a dielectric layer and the active and passive waveguide regions are applied in a single coating process by deposition of semiconductor material from the gaseous phase, **characterised in that** the composition of the constituents in the gaseous phase is adjusted so that the semiconductor layers with the small band gap energy (WELL) are biaxially tensile strained in such a way that in the active waveguide regions light of a specific wavelength range that is polarised in the plane of the substrate is amplified or absorbed to the same extent as light polarised perpendicular to the plane of the substrate, and that the semiconductor layers with the large band gap energy (BAR) have a larger lattice constant in the active regions (A) than the substrate (SUB).

6. Process according to claim 5, **characterised in that** the substrate consists of InP and the semiconductor layers consist of InGaAsP or InGaAs, and in the gaseous phase the proportion of Ga-containing constituents is increased compared to the composition of the constituents in the gaseous phase at which the semiconductor layers grow with a lattice constant adapted to the substrate (SUB) .

## Revendications

1. Composant optoélectronique à semi-conducteur intégré avec des zones de guide d'onde optiques actives (A) et passives (P), disposées sur un substrat cristallin (SUB), qui comportent dans la direction de propagation de la lumière des parties étrcites longitudinales d'un ensemble de couches semi-conductrices continu et cohérent (SP), cet ensemble de couches semi-conductrices a une pluralité de couches semi-conductrices avec en alternance une faible énergie de bande interdite (WELL) et une forte énergie de bande interdite (BAR) et les couches semi-conductrices ont une plus grande épaisseur de couche dans les zones de guide d'onde actives (A) que dans les zones de guide d'onde passives (P), les couches semi-conductrices à faible énergie de bande interdite (WELL) étant déformées par traction, **caractérisé en ce que** les couches semi-conductrices à faible énergie de bande interdite (WELL) sont déformées par traction biaxialement de telle sorte que dans les zones de guide d'onde actives, la lumière d'une certaine plage de longueurs d'onde, polarisée dans le plan du substrat, est amplifiée ou absorbée dans la même mesure que la lumière polarisée perpendiculairement au plan du substrat, et en ce que les couches semi-conductrices à forte énergie de bande interdite (BAR) présentent dans les zones actives (A) une plus grande constante de grille que le substrat (SUB).

2. Composant à semi-conducteur selon la revendication 1, **caractérisé en ce que** les couches semi-conductrices à faible énergie de bande interdite (WELL) présentent une plus petite constante de grille dans les zones passives (P) que dans les zones actives (A).

3. Composant à semi-conducteur selon la revendication 1 ou 2, **caractérisé en ce que** les couches semi-conductrices à forte énergie de bande interdite (BAR) présentent dans les zones passives (P) la même constante de grille que le substrat (SUB).

4. Composant à semi-conducteur selon l'une quelconque des revendications 1 à 3, **caractérisé en ce que** deux zones de guide d'onde actives (A1, A2) sont connectées optiquement en parallèle par l'intermédiaire de branchements passifs en forme de Y (Y1, Y2) et ont un accès photoconducteur (Z1) commun et l'une des zones de guide d'onde active (A1) présente un deuxième accès photoconducteur (Z2) par l'intermédiaire d'un autre branchement passif en forme de Y (Y3) .

5. Procédé de fabrication d'un composant optoélectronique à semi-conducteur intégré avec des zones de guide d'onde optique actives (A) et passives (P), disposées sur un substrat, qui comportent respectivement une pluralité de couches semi-conductrices (SP), dans lequel les zones de guide d'onde actives sont disposées entre des zones de la surface de substrat recouvertes par une couche diélectrique et les zones de guide d'onde actives et passives sont appliquées dans un processus de couchage unique par dépôt d'un matériau semi-conducteur à partir de la phase gazeuse, **caractérisé en ce que** la composition des composantes en phase gazeuse est ajustée de telle sorte que les couches semi-conductrices à faible énergie de bande interdite (WELL) sont déformées par traction biaxialement de telle sorte que dans les zones de guide d'onde actives, la lumière d'une certaine plage de longueurs d'onde, polarisée dans le plan du substrat, est amplifiée ou absorbée dans la même mesure que la lumière polarisée perpendiculairement au plan du substrat, et en ce que les couches semi-conductrices à forte énergie de bande interdite (BAR) présentent dans les zones actives (A) une plus grande constante de grille que le substrat (SUB) .

6. Procédé selon la revendication 5, **caractérisé en ce que** le substrat se compose d'InP et les couches semi-conductrices se composent d'InGaAsP ou d'InGaAS, et en phase gazeuse, la proportion des composantes comportant du Ga est augmentée par rapport à la composition des composantes en phase gazeuse dans laquelle les couches semi-conductrices se forment avec une constante de grille adaptée au substrat (SUB).
